# EUROPÄISCHE PATENTANMELDUNG

(11) **EP 0 768 722 A1**
(43) Veröffentlichungstag der Anmeldung: **16.04.1997**
(21) Anmeldenummer: 96113227.1
(22) Anmeldetag: 17.08.1996
(51) Int. Cl.: H01L 45/00

(54) **Verfahren zur Herstellung eines elektronischen Schaltelementes**

(30) Priorität: 13.10.1995 DE 19538128
(71) Anmelder: Lüder, Ernst, Prof. Dr.-Ing. habil., D-70550 Stuttgart (DE)
(72) Erfinder: Klette, Rüdiger, Dipl.-Ing., 70806 Kornwestheim (DE); Maresch, Stefan, Dipl.-Ing., 73728 Esslingen (DE); Lüder, Ernst, Prof. Dr.-Ing. habil., 70550 Stuttgart (DE)
(74) Vertreter: Möbus, Daniela, Dr.-Ing.

(57) **Zusammenfassung**

Ein Verfahren zur Herstellung eines elektronischen Schaltelementes bestehend aus einer Schichtfolge Metall-Isolator-Metall auf einem Substrat aus Folienmaterial (10), bei dem das Folienmaterial (10) mit einer dielektrischen Haftschicht (11) versehen wird und als Grundelektrode des Bauelementes eine Sandwich-Struktur aus einer Schicht (12) aus einem anodisierbaren Metall, einer Schicht (13) aus einem duktilen anodisierbaren Metall und erneut einer Schicht (14) aus anodisierbarem Metall gebildet wird und der Isolator durch Anodisation dieser Schichtenfolge (12 bis 14) entsteht.

## Beschreibung

Die Erfindung betrifft ein Verfahren zur Herstellung eines elektronischen Schaltelementes bestehend aus einer Schichtfolge Metall-Isolator-Metall auf einem Substrat aus Folienmaterial und insbesondere eingesetzt zur aktiven Steuerung von Bildpunkten einer Flüssigkristallanzeige.

Der Einsatz solcher als MIM (Metall-Isolator-Metall)-Elemente bezeichneter Schaltelemente zur Ansteuerung von Flüssigkristalldisplays, die auf Glassubstraten aufgebracht sind, ist seit mehreren Jahren bekannt, und es gibt eine ganze Reihe von Verfahren zur Herstellung dieser MIM-Elemente. Neuerdings werden jedoch auch aktive Flüssigkristalldisplays auf Kunststoffolien gefertigt. Auch zur Ansteuerung dieser Displays lassen sich MIM-Elemente einsetzen, wobei sich jedoch eine einfache Übertragung der Herstellungsverfahren dieser Elemente auf Glassubstraten aufgrund der mechanischen und thermischen Verformbarkeit des Folienmaterials verbietet. Insbesondere kann der bei Glassubstraten vielfach verwendete Aufbau der Grundelektrode eines MIM-Bauelementes aus reinem Tantalmaterial bei Foliensubstraten nicht realisiert werden, da dieses Material aufgrund seiner Sprödigkeit bereits beim Aufbringen als Schicht auf einem Folienmaterial sofort Risse bildet. Darüber hinaus sind die bei Glassubstraten angewandten Temperschritte mit Temperaturen von 300°C und mehr bei Kunststoffolien als Substrat aufgrund deren sehr viel niedrigeren Schmelzpunktes nicht durchführbar.

Der vorliegenden Erfindung liegt die Aufgabe zugrunde, eine Möglichkeit der Herstellung von MIM-Elementen auch auf Foliensubstraten zu ermöglichen.

Die Aufgabe wird mit einem Verfahren der eingangs genannten Art gelöst, das erfindungsgemäß durch die Schritte gekennzeichnet ist:
- Abscheidung einer dielektrischen Haftschicht auf der Oberfläche des Foliensubstrates,
- Abscheidung einer Schicht aus einem anodisierbaren Metall, dann einer Schicht aus einem duktilen anodisierbaren Metall und erneut einer Schicht aus einem anodisierbaren Metall,
- Strukturierung der Schichtfolge durch Ätzen oder ein Lift-Off-Verfahren,
- Anodisation der Oberfläche der strukturierten Metallschichtenfolge;
- Abscheidung einer leitfähigen Metallschicht oder ITO als Deckelektrode,
- Strukturierung der Deckelektrode.

Das Foliensubstrat kann dabei aus Kunststoff bestehen und zweckmäßigerweise in Vakuum thermisch vorbehandelt sein, um Unebenheiten aus dem Folienmaterial zu entfernen und im Kunststoff gegebenenfalls enthaltene restliche Lösungsmittel und andere chemische Verunreinigungen auszugasen. Aufgrund der dielektrischen Haftschicht, die beispielsweise aus gesputtertem Tantalpentoxid oder Siliziumdioxid bestehen kann, erhält die anschließend aufgebrachte Struktur einen guten Halt auf dem Foliensubstrat. Bei der dreiteiligen Schichtfolge aus unterschiedlichen Metallen kann die unterste, direkt auf der Haftschicht plazierte Metallschicht sehr dünn gehalten werden. Hierdurch ist eine Ausbildung von Rissen, auch bei Verwendung von Tantal für diese Schicht nicht zu befürchten. Diese Schicht dient dazu, eine Ablösung des Strukturaufbaus durch die spätere Anodisation der duktilen Metallzwischenschicht, die vorzugsweise aus Aluminium bestehen kann, zu verhindern. Die Strukurierung des Schichtaufbaus erfolgt entweder durch stufenweises Ätzen oder ein Lift-Off-Verfahren. Für die Oberflächenanodisation des Metallaufbaus kann vorzugsweise ein flüssiger Elektrolyt, beispielsweise 0,01 %-ige, in deionisiertem Wasser verdünnte Zitronensäure verwendet werden. Die dabei entstehende Oxidschicht bildet den Isolator des Bauelementes, auf den anschließend die Deckelektrode abgeschieden wird. Auch die Strukturierung der Deckelektrode kann entweder durch Ätzen oder Lift-Off-Technik erfolgen. Dabei ist die Strukturierung von Schichten auf Kunststoffoliensubstraten nicht ganz einfach. Die Belichtung des Fotolackes in einem Kontaktbelichter bereitet bei diesen Kunststoffolien besondere Probleme. Eine in ihren Abmessungen originalgetreue Abbildung einer auf einer Maske enthaltenen Struktur kann aufgrund der Flexibilität des Kunststoffmaterials nur durch eine sogenannte Hard-Contact-Belichtung erreicht werden. Hierbei kann das mit einer Fotolackschicht versehene Folienmaterial durch atmosphärischen Überdruck fest an die beispielsweise aus Chrom bestehende Maske mit der maßstabsgetreuen Abbildung der zu bildenden Struktur gepreßt werden, wobei die Maske mit einer Antihaftschicht versehen ist, um ein Ankleben des Fotolacks an der Maske zu verhindern. Ohne diese Antihaftschicht, die beispielsweise aus einer 10 - 20 nm dicken gesputterten SiO₂-Schicht bestehen kann, würde durch den großen Anpreßdruck zwischen dem Fotolack und der Maske eine sehr stark haftende Verbindung entstehen, die bei der nachfolgenden Belichtung dazu führen würde, daß Teile des Fotolacks von der Oberfläche des Substrates abgelöst werden und auf der Maske haften.

Das elektronische Schaltelement, das nach einem erfindungsgemäßen Verfahren hergestellt wird, ist auf einem mit einer dielektrischen Haftschicht versehenen Foliensubstrat aufgebracht, und seine Grundelektrode besteht aus einer Sandwichstruktur aus einem anodisierbaren Metall, vorzugsweise Tantal, und einem duktilen anodisierbaren Metall, vorzugsweise Aluminium.

Nachfolgend werden anhand der Zeichnung die einzelnen Schritte eines erfindungsgemäßen Verfahrens näher erläutert.

Es zeigen:
- Fig. 1 a - c: eine schematische Darstellung der Verfahrensschrittfolge zur Herstellung eines Schaltelementes;
- Fig. 2: eine schematische Darstellung eines Fotolithographieverfahrens für Kunststoffoliensubstrate.

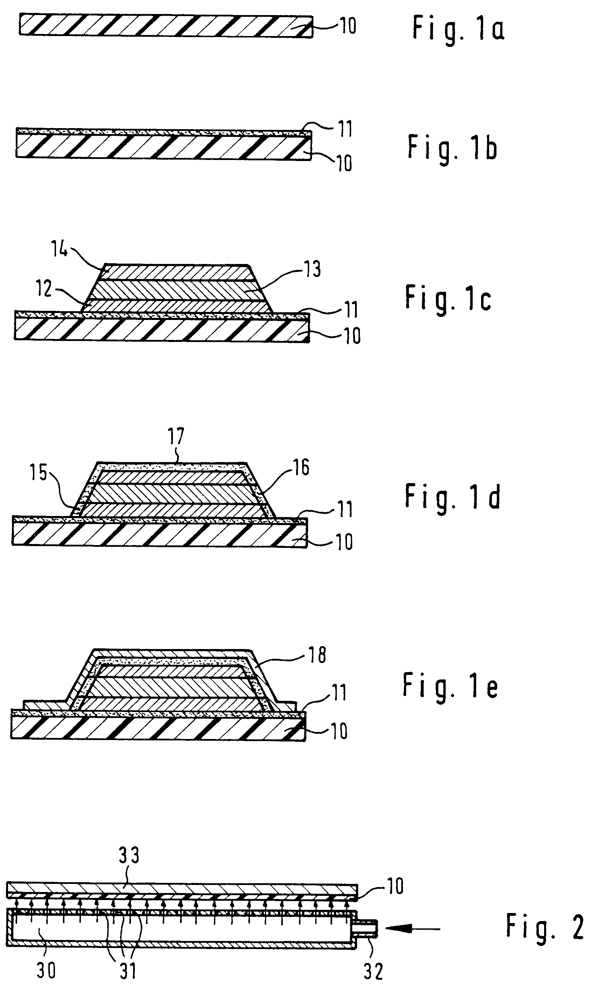

Fig. 1 a zeigt ein Foliensubstrat 10 aus Kunststoff. Dieses Kunststoffsubstrat 10 wird durch Vakuumtemperung bei Temperaturen unter 250°C vorbehandelt, um Unebenheiten aus dem Folienmaterial zu entfernen und im Kunststoff enthaltene Reste von Lösungsmitteln und anderen chemischen Verunreinigungen auszugasen. Im nächsten, in Fig. 1 b gezeigten Verfahrensschritt wird auf der Oberfläche des Kunststoffsubstrates 10 eine dielektrische Haftschicht 11 abgeschieden, die beispielsweise aus gesputtertem Tantalpentoxid oder Siliziumdioxid bestehen kann. Hierauf wird eine Sandwich-Metallisierungsschicht zur Bildung der Grundelektrode des Elementes abgeschieden, die nach Fig. 1 c aus einer ersten Schicht 12 aus einem anodisierbaren Metall wie Tantal, dann einer Schicht 13 aus einem duktilen und ebenfalls anodisierbaren Metall wie Aluminium und einer Deckschicht 14 wieder aus dem gleichen Material wie die Schicht 12, also dem anodisierbaren Metall, besteht. Die Strukturierung des Schichtaufbaus erfolgt entweder durch stufenweises Ätzen oder Lift-Off-Verfahren. Die direkt über der dielektrischen Haftschicht plazierte Metallschicht 12 ist sehr dünn. Sie soll beim nächsten, in Fig. 1 d gezeigten Verfahrensschritt, in dem die Oberflache der Metallschichtfolge 12, 13, 14 anodisiert wird, eine Ablösung des Strukturaufbaus durch die Anodisation der duktilen Metallzwischenschicht 13 verhindern. Die Oberflächenanodisation nach Fig. 1 d erfolgt in einem flüssigen Elektrolyten, beispielsweise in 0,01 %-iger, in deionisiertem Wasser verdünnter Zitronensäure. Es bilden sieh dabei Oxide der Metalle der Schichten 12 bis 14, die sieh als Deckschicht mit den Bereichen 15, 16 und 17 über die Struktur legen. Nach der Anodisation wird eine Deckelektrode 18 aus einer duktilen Metallschicht, beispielsweise aus Titan oder ITO, abgeschieden und anschließend durch Ätzen oder Lift-Off-Technik strukturiert.

Fig. 2 zeigt die Lösung der technischen Probleme beim Strukurieren von Schichten auf Kunststoffolien. Durch die flexiblen Eigenschaften der Kunststoffolien erschwert sieh die originalgetreue Abbildung einer auf einer Maske aufgebrachten Struktur auf die Folie. Es wird daher ein Substrattisch 30 mit einer Vielzahl von Oberflächenöffnungen 31 eingesetzt, der durch eine seitliche Öffnung 32 mit Druckluft beschickt wird. Die Druckluft preßt das mit einer nicht näher dargestellten Fotolackschicht versehene Kunststoffoliensubstrat 10 fest gegen eine Belichtungsmaske 33 aus Chrom. Die Belichtungsmaske 33 ist dabei auf ihrer dem Substrat 10 zugewandten Seite mit einer Antihaftschicht aus Si0₂ versehen, die eine Haftung des Fotolacks aufgrund des großen Anpreßdruckes zwischen Substrat 10 und Maske 33 bei der nachfolgenden Belichtung zuverlässig verhindert. Selbstverständlich können nach diesem Verfahren auch andere Bauelemente als MIM-Elemente strukturiert werden.

## Patentansprüche

1. Verfahren zur Herstellung eines elektronischen Schaltelementes bestehend aus einer Schichtfolge mit Metall-Isolator-Metall auf einem Substrat aus Folienmaterial und insbesondere eingesetzt zur aktiven Ansteuerung von Bildpunkten einer Flüssigkristallanzeige, gekennzeichnet durch die Schritte:
- Abscheidung einer dielektrischen Haftschicht (11) auf der Oberfläche des Foliensubstrates (10),
- Abscheidung einer Schicht (12) aus einem anodisierbaren Metall, dann einer Schicht aus einem duktilen, anodisierbaren Metall (13) und erneut einer Schicht (14) aus einem anodisierbaren Metall,
- Strukturierung der Schichtfolge (12, 13, 14) durch Ätzen oder ein Lift-Off-Verfahren,
- Anodisation der Oberfläche der strukturierten Metallschichtenfolge (12, 13, 14);
- Abscheidung einer leitfähigen Metallschicht oder ITO als Deckelektrode (18),
- Strukturierung der Deckelektrode (18).

2. Verfahren nach Anspruch 1, dadurch gekennzeichnet, daß das Foliensubstrat aus Kunststoff besteht und im Vakuum zur Beseitigung von Unebenheiten und Entfernung von chemischen Verunreinigungen thermisch vorbehandelt wird.

3. Verfahren nach Anspruch 1 oder 2, dadurch gekennzeichnet, daß die Haftschicht (11) aus Tantalpentoxid oder Siliziumdioxid besteht.

4. Verfahren nach einem der Ansprüche 1 bis 3, dadurch gekennzeichnet, daß als anodisierbares Metall (12, 14) Tantal und als duktiles anodisierbares Metall (13) Aluminium abgeschieden wird.

5. Verfahren nach einem der Ansprüche 1 bis 4, dadurch gekennzeichnet, daß die Oberflächenanodisation der strukturierten Metallschichtenfolge (12, 13, 14) in einem flüssigen Elektrolyten, vorzugsweise in 0.01 %-iger in deionisiertem Wasser verdünnter Zitronensäure, durchgeführt wird.

6. Verfahren nach einem der Ansprüche 1 bis 5, dadurch gekennzeichnet, daß die Deckelektrode (18) aus Titan oder ITO besteht.

7. Verfahren nach einem der Ansprüche 1 bis 6, dadurch gekennzeichnet, daß die Strukturierung der Schichten (12, 13, 14, 18) des elektronischen Schaltelementes mit einem fotolithographischen Verfahren erfolgt, bei dem das mit einer Fotolackschicht versehene Folienmaterial (10) durch atmosphärischen Überdruck fest an eine Maske (33) mit einer maßstabsgetreuen Abbildung der zu bildenden Struktur gepreßt wird, wobei die Maske (33) mit einer Antihaftschicht versehen ist, um ein Ankleben des Fotolacks an der Maske (33) zu verhindern.

8. Verfahren nach Anspruch 7, dadurch gekennzeichnet, daß die Maske (33) aus Chrom besteht und als Antihaftschicht eine SiO₂-Schicht auf die Maske (33) aufgesputtert wird.

9. Elektronisches Schaltelement, hergestellt nach einem Verfahren gemäß einem der Ansprüche 1 bis 8, dadurch gekennzeichnet, daß es auf einem mit einer dielektrischen Haftschicht (11) versehenen Foliensubstrat (10) aufgebracht ist und die Grundelektrode eine Sandwich-Struktur aus einem anodisierbaren Metall (12, 14), vorzugsweise Tantal, und einem duktilen anodisierbaren Metall (13), vorzugsweise Aluminium, aufweist.
